(19)

Europäisches
Patentamt
European
Patent Office
Office européen
des brevets

(11) **EP 4 462 630 A1**

(12) **EUROPEAN PATENT APPLICATION**

(43) Date of publication:
**13.11.2024 Bulletin 2024/46**

(21) Application number: **23305747.0**

(22) Date of filing: **11.05.2023**

(51) International Patent Classification (IPC):
*H02J 3/28* (2006.01)          *C25B 15/02* (2021.01)
*H02J 7/00* (2006.01)

(52) Cooperative Patent Classification (CPC):
**H02J 3/28; C25B 15/02; H02J 7/0047;**
H02J 2203/20; H02J 2300/20

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **TOTALENERGIES ONETECH
92400 Courbevoie (FR)**

(72) Inventors:
• **Dubouis, Nicolas**
  **Courbevoie (FR)**
• **Maréchal, William**
  **Courbevoie (FR)**

(74) Representative: **Bandpay & Greuter
11 rue Christophe Colomb
75008 Paris (FR)**

(54) **PERFORMANCE EVOLUTION PREDICTION FOR AN APPARATUS SUBJECT TO AN INTERMITTENT LOAD**

(57) The disclosure notably relates to a computer-implemented method of generating a predictive model configured for outputting a predicted evolution of a performance indicator for an electrochemical apparatus subject to an anticipated intermittent load at least partly produced by one or more renewable energy sources. The method comprises obtaining a plurality of time series each representing a respective real intermittent load at least partly produced by one or more renewable energy sources, machine-learning a plurality of basis functions each representing a respective elementary intermittent load, and determining a plurality of elementary evolutions comprising, for each basis function, a respective elementary evolution of the performance indicator for the electrochemical apparatus. The predictive model comprises a projection of the anticipated intermittent load on the plurality of basis function, thereby obtaining a respective succession of linear combinations, and an application of the respective succession of linear combinations to the plurality of elementary evolutions.

EP 4 462 630 A1

## Description

## TECHNICAL FIELD

The disclosure relates to the field of computer programs and systems, and more specifically to a method, system and program for generating a predictive model configured for outputting a predicted evolution of a performance indicator for an electrochemical apparatus subject to an anticipated intermittent load.

## BACKGROUND

As part of the energy transition, exploiting electrochemical apparatuses to store and/or release electric energy in an intermittent manner becomes of paramount importance. In this context, the demand for green hydrogen is increasing at a significant pace. Indeed a significant process for green hydrogen production is to feed electricity generated from a renewable energy source into an electrolyzer. For instance, a water electrolyzer can be used to produce hydrogen while being coupled to renewable sources. Electrolyzers usually operate with a constant and steady input, but a renewable energy source is characterized by its fluctuating nature. Applying intermittent loads with such fluctuating profiles to an electrochemical apparatus can drastically modify its behavior, especially it may result in increasing the degradation of said apparatus, and thus reducing their performances. The degradation rate can drastically impact the operability of the project. However, experimental tests to predict degradation are rather too long or not representative of all the renewable profiles.

There exists a group of white-box models integrating physical-chemical mechanisms responsible for the ageing and degradation of an electrochemical apparatus. On the other hand, black-box family of models seek to predict performance of an apparatus without any knowledge of its internal workings. Such black-box models may be based on a machine learning approach. In general, the physical phenomenon inside an electrochemical apparatus is governed by complicated multiphysics which impedes providing fast and simple realtime white-box modelling. On the other hand, obtaining an accurate black-box model requires a significant amount of training data.

Within this context, there is still a need for an improved solution for predicting evolution of a performance indicator for an electrochemical apparatus subject to an anticipated intermittent load.

## SUMMARY

It is therefore provided a computer-implemented method of generating a predictive model configured for outputting a predicted evolution of a performance indicator for an electrochemical apparatus subject to an anticipated intermittent load at least partly produced by one or more renewable energy sources. The method comprises obtaining a plurality of time series each representing a respective real intermittent load at least partly produced by one or more renewable energy sources and configured for subjecting the electrochemical apparatus. The method further comprises machine-learning a plurality of basis functions each representing a respective elementary intermittent load. The plurality of basis function forms a projection space for the plurality of time series. The plurality of basis functions is thereby configured for approximating each time-series by a respective succession of linear combinations applied to the plurality of basis functions. The method further comprises determining a plurality of elementary evolutions comprising, for each basis function, a respective elementary evolution of the performance indicator for the electrochemical apparatus, if the electrochemical apparatus is subjected to the respective elementary intermittent load represented by the basis function. The predictive model comprises a projection of the anticipated intermittent load on the plurality of basis function, thereby obtaining a respective succession of linear combinations applicable to the plurality of basis functions to approximate the anticipated intermittent load; and an application of the respective succession of linear combinations to the plurality of elementary evolutions, thereby outputting the predicted evolution.

The method may comprise one or more of the following:

- the determining of a respective elementary evolution of the performance indicator for the electrochemical apparatus comprises, for each basis function:

  ○ obtaining at least one physical instance of the electrochemical apparatus;
  ○ subjecting the at least one physical instance of the electrochemical apparatus to at least one actual instance of the respective elementary intermittent load represented by the basis function;
  ○ performing at least one measurement of the performance indicator on the at least one physical instance of the electrochemical apparatus; and
  ○ computing the respective elementary evolution based on the at least one measurement;

- the at least one measurement of the performance indicator on the at least one physical instance of the electrochemical apparatus comprises a first measurement and a second measurement, the first measurement being performed at a start of the at least one actual instance of the respective elementary intermittent load, the second measurement being performed at an end of the at least one actual instance of the respective elementary intermittent load, the computing of the respective elementary evolution comprising calculating a difference between a value obtained from the second measurement and a value obtained from first measurement;

- for at least one basis function, the at least one actual instance of the respective elementary intermittent load represented by the basis function comprises a plurality of actual instances of the respective elementary intermittent load;

- each time series comprises a respective classification label, and the machine-learning of the plurality of basis functions comprises minimizing, for each time series: a classification error with respect to the classification label, and/or a distance metric between the basis function and the provided time series;

- the distance metric is a dynamic time wrapping, and/or the classification error is a cross-entropy loss;

- the plurality of basis functions comprises a plurality of shapelets;

- each shapelet comprises a length parameter, the machine-learning of the plurality of basis functions further comprising determining a length of each shapelet so as to minimize an error;

- the machine-learning of the plurality of basis functions further comprises selecting a subset of a predetermined size from the determined plurality of basis functions; the selected subset having a classification error in a first vicinity of the minimizing classification error, and/or a distance metric in a second vicinity of the minimizing distance metric;

- the performance indicator represents an efficiency in constant mode, a temperature signal, a pressure signal, an ion concentration signal, or a gas concentration signal; and/or

- the electrochemical apparatus comprises at least one of an electrolyzer connected to an intermittent source of power, an electrochemical energy storage device connected to an intermittent source of power, and an electrochemical energy storage device connected to an intermittent load.

It is further provided a computer-implemented method of using a predictive model generated according to the method discussed above for a respective electrochemical apparatus. The method of using comprises obtaining an anticipated intermittent load at least partly produced by one or more renewable energy sources; and applying the predictive model to the anticipated intermittent load, thereby outputting a predicted evolution of the performance indicator for the respective electrochemical apparatus, if the respective electrochemical apparatus is subjected to the anticipated intermittent load. The applying of the predictive model includes projecting the anticipated intermittent load on the plurality of basis function, thereby obtaining a respective succession of linear combinations applicable to the plurality of basis functions to approximate the anticipated intermittent load; and applying the respective succession of linear combinations to the plurality of elementary evolutions, thereby outputting the predicted evolution.

It is further provided a computer program comprising instructions for performing any of the methods discussed above.

It is further provided a computer readable storage medium having recorded thereon the computer program.

It is further provided a system comprising a processor coupled to a memory and a graphical user interface, the memory having recorded thereon the computer program.

## BRIEF DESCRIPTION OF THE DRAWINGS

Non-limiting examples will now be described in reference to the accompanying drawings, where:

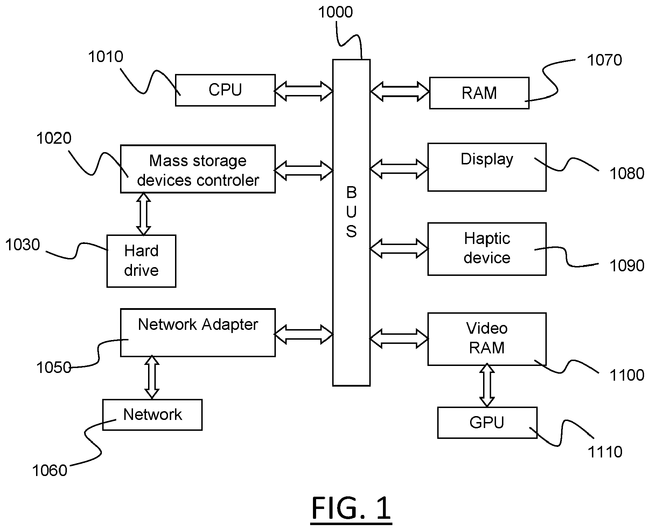

- FIG. 1 shows an example of the system; and
- FIG.s 2-7 present examples of the method.

## DETAILED DESCRIPTION

It is proposed a computer-implemented method of generating a predictive model. The predictive model is configured for outputting a predicted evolution of a performance indicator for an electrochemical apparatus, the electrochemical apparatus being subject to an anticipated intermittent load. The intermittent load is at least partly produced by one or more renewable energy sources. The method comprises obtaining a plurality of time series. Each of the time series represents a respective real intermittent load at least partly produced (i.e., formed) by one or more renewable energy sources. Each respective real intermittent load is configured for subjecting the electrochemical apparatus. The method further comprises a machine-learning approach which identifies a plurality of basis functions. Each basis function represents a respective elementary intermittent load. The plurality of basis functions forms a projection space for the plurality of time series. The plurality of basis functions is thereby configured for approximating each time-series by a respective succession of linear combinations applied to the plurality of basis functions. The method further comprises determining a plurality of elementary evolutions. The plurality of elementary evolutions comprises, for each basis function, a respective elementary evolution of the performance indicator for the electrochemical apparatus, if the electrochemical apparatus is subjected to the respective elementary intermittent load represented by the basis function. The predictive model comprises projection of the anticipated intermittent load on the plurality of basis function, thereby obtaining a respective succession of linear combinations. The respective succession of linear combinations is applicable to the plurality of basis functions, to approximate the anticipated intermittent load. The predictive model further comprises application of the respective succession of linear combinations to the plurality of elementary evolutions, thereby outputting the predicted evolution.

The method constitutes an improved solution for predicting evolution of a performance indicator of an electrochemical apparatus. The method provides a simple tool to predict an evolution of a performance indicator for such an apparatus. Such a prediction is particularly important for electrochemical apparatuses subject to intermittent loads at least partly produced by a renewable energy source. For instance, in the case of renewable energy resources like wind and solar resource are not constantly available (due to unavoidable variations in the sun's position and meteorological conditions) and hardly predictable, renewable energy sources result in an intermittent load. The one or more renewable energy sources producing at least partly the anticipated intermittent load and/or the one or more renewable energy sources producing at least partly one or more (e.g., each) of the respective real intermittent loads represented by the plurality of time series may comprise any one or any combination of a solar energy source, a wind energy source, and a hydropower energy source. Providing such a load to an apparatus, for example, an electrochemical apparatus, results in much more significant deterioration of performance on said apparatus (e.g., compared to a constant load).

The evolution or modification of a performance indicator is tightly related to prediction of said performance indicator upon defining an initial condition for the performance indicator. Such an initial condition for a performance indicator, for example, an efficiency for the electrochemical apparatus, is generally known for an electrochemical apparatus, for example by the manufacturer. Thereby, hereinbelow the expressions "prediction of evolution of a performance indicator" and "prediction of a performance indicator" may be used interchangeably.

The method does not require complex hardware and/or measurement techniques and may rely (e.g., solely) on processing of data simply obtainable from the apparatus and computations based on said data. This tool is notably based on the key observation that an evolution of a performance for an anticipated (intermittent) load may be obtained as a succession of linear combinations of elementary evolutions (of said performance indicator). The elementary evolutions represent an effect of an elementary load (represented by a respective basis function) on the performance evolution. The method obtains a plurality of said elementary loads by performing a machine-learning among the provided plurality of time series and determines each respective elementary evolution, for example by performing a respective experiment. Said experiment consists in subjecting the electrochemical apparatus to the respective elementary intermittent load and to determine the respective elementary evolution by observing/measuring the respective evolution of the performance indicator.

The tool provided by the method is further beneficial in providing an efficient online/offline task separation. Upon the generation of the predictive model in an offline mode, the method is ready to receive an anticipated load online, to project it on the plurality of basis functions to obtain a succession of linear combinations, and to apply the obtained linear combination to the already determined plurality of elementary evolutions. Thereby, the online stage is merely a projection of the provided online load and an application of a respective linear combinations on a set of determined values, which is significantly faster and less computationally costly than the offline stage. This improves the real-time performance of the method.

Furthermore, in the context of the proposed method, it has been observed that the decomposition of the anticipated load via said projection into a succession of linear combinations of (reduced numbers) basis functions does not result in the significant loss of relevant information with respect to the task at hand. Thereby, the method is able to provide a prediction of the evolution of the performance indicator with a high level of precision.

By an "electrochemical apparatus" it is meant an apparatus comprising at least one electrochemical cell. An electrochemical cell, as known *per se,* is a device capable of either generating electrical energy from chemical reactions or using electrical energy to cause chemical reactions. In examples, the electrochemical apparatus may comprise at least one of an electrolyzer (configured/contemplated to be) connected to an intermittent source of power (and configured to consume electrical power received from said source to perform an electrolysis process), an electrochemical energy storage device (configured/contemplated to be) connected to an intermittent source of power (and configured to convert electrical power of the source into a chemical potential energy of said energy storage device), and an electrochemical energy storage device (configured/contemplated to be) connected to an intermittent load (and configured to receive energy from or emit energy to said load). Thereby, by an "intermittent load" it is meant emitting or receiving of power in an intermittent manner, in other words, positive or negative intermittent energy change. On the other hand, an "intermittent source of power" is an intermittent supply of power, in other words, a particular form of the intermittent load. In other words, an intermittent load may relate to an electrochemical device that operates either in "receiver" mode (e.g., an electrolyzer connected to a renewable source) or in "sender" mode (e.g., a battery connected to an engine that has intermittent operation).

The expression "the electrochemical apparatus" thereby signifies a class of electrochemical apparatuses of a same type and using the same operating parameters. In particular, the method may generate a predictive model for an electrochemical apparatus of a certain class where the generated model is applicable to all apparatuses of the certain class (e.g., same model/reference from the same brand). This provides a universal predictability functionality by the method.

By "performance indicator for an electrochemical" it is meant any indicator used in the technical field to evaluate a performance of said electrochemical apparatus. For example, the performance indicator may be an output voltage or current of the electrochemical apparatus. Alternatively, the performance indicator may be an efficiency of said apparatus. The efficiency of the apparatus may be any efficiency used in the field. For example, the efficiency of an apparatus may be a ratio of the output energy of the apparatus to the input energy of the apparatus.

In other examples, the performance indicator may represent any of an efficiency in constant mode, a temperature signal, a pressure signal, an ion concentration signal, or a gas concentration signal. By an "efficiency in a constant mode" it is meant a ratio of an efficiency of the apparatus (i.e., when the apparatus is subject to an intermittent load) to an efficiency for a constant load. As discussed above, being subject to an intermittent load might degrade the efficiency with time compared to the efficiency for a constant load. The pressure signal and the temperature signal may be pressure/temperature signal from the apparatus, for example from a reservoir in the apparatus (e.g., a reservoir/pipe configured to collect/transport the produced hydrogen (H2) and oxygen (O2) upon an electrolysis). The pressure or temperature signal may be obtained by using any type of known pressure/temperature sensor. The gas concentration may be a signal representing a concentration of an element in the apparatus, for example a concentration of O2 in H2 reservoir/pipe and/or a concentration of H2 in an O2 reservoir/pipe of an electrolyzer. The concentration signal may be obtained by using any type of known apparatus/method, for example optical sensors, mass spectrometry, or gas chromatography. As known, H2 and oxygen O2 obtained from the electrolysis in an electrolyzer are stored in a hydrogen and oxygen vessel/reservoir respectively (HV and OV, respectively), where they are separated from the entrained electrolyte. The pressure between two vessels (i.e., anodic and cathodic circuit) may be different.. During the electrolysis process a certain percentage (e.g., volume percentage) of H2 may cross barriers installed between the vessels (e.g., a gas separator) to the O2 reservoir and vice versa a certain percentage of O2 may be in the H2 reservoir. In particular, the vol. % O2 in H2 reservoir may be connected to an alarm for safety reasons, ensuring that oxygen concentration does not approach the low explosivity limit of the gas mixture. A similar alarm system may be set regarding the pressure and/or temperature in each of the vessels to alert a potential overpressure/temperature in said reservoir. The gas composition/pressure/temperature in each reservoir may vary with the load. Such variations does not allow the apparatus to function in a continuous mode and impose transient behaviour. The apparatus does not operate in continuous mode but in transient. Known methods of control for system dynamics is not as fast as the variations of the load. Therefore, the controlling of such an apparatus is a challenging problem. In particular, an apparatus subject to an intermittent load is more prone to experience explosivity limit of O2 in HV, overpressure, and/or overtemperature. Thereby, it is more vital for an electrochemical apparatus subject to this kind of loads to be equipped with an accurate and fast prediction model.

By "evolution of a performance indicator for an electrochemical apparatus" it is meant a temporal behavior of said indicator during a time period of functioning of said apparatus. The evolution of a performance indicator for an electrochemical apparatus may represent a degradation, i.e., a decrease of the efficiency and/or capacity over time (i.e., between an initial time and a time instant). By a "predictive model configured for outputting a predicted evolution of a performance indicator for an electrochemical apparatus" it is meant a model which accepts, as input, data regarding the electrochemical apparatus, and which outputs a plurality of values representing an evolution of the performance indicator of said apparatus.

As known in the field of electrical engineering, renewable energy sources often produce a load operating only a fraction of a 24-hour period. The one or more renewable energy sources partly producing each intermittent load may comprise (e.g., consist of) such renewable energy sources. The intermittent load may be a load with an oscillatory behavior (e.g., due to oscillations of said one or more renewable energy sources) which may also disappear in some time periods. The notion of intermittent load may also be defined in contrary to continuous loads which usually defined as those that operate continuously for long periods of time. In other words, continuous loads are loads which persist continuously for a long time under the same conditions. On the other hand, intermittent loads are loads which persist for a short time and are then shut down either for a long duration or a very short duration. Application of intermittent load covers an electrochemical device which operates in "receiver" mode (for example an electrolyser connected to renewables) or in "transmitter" mode (for example a battery connected to a motor which has intermittent load). The intermittent load is at least partly produced by one or more renewable energy sources, for example one or more of solar energy sources, wind energy sources, geothermal energy sources, and/or ocean energy sources.

The method comprises obtaining a plurality of time series each representing a respective real intermittent load. The real intermittent load may be a load that has been observed in reality. In other words, the real intermitted load is the record of energy production of electrochemical apparatuses, e.g., photovoltaic or wind power systems. These records are often made by so-called Supervisory Control And Data Acquisition (SCADA) systems. Furthermore, the real intermittent load may be a historical load, i.e., a load that has been measured over a period in the past and stored in a database. In other words, the time series representing the real intermittent load is a history of said intermittent load. Alternatively, the real intermittent load may be a generated load (i.e., the respective time series may be artificially generated). For instance, the time series may have been constructed by generating a wind power production from a wind profile and wind turbine characteristics. The plurality of time series may thus comprise time series of loads that have been observed in reality and/or historical loads, and/or generated time series. Optionally, the plurality of time series may exclusively (i.e., for 100% of the time series) or substantially exclusively (e.g., for more than 90% of the time series) consist of time series of loads that have been observed in reality and/or historical loads.

Each intermittent load is partly produced by one or more renewable energy sources and configured for subjecting the electrochemical apparatus. By the load being "configured for subjecting the electrochemical apparatus" it is meant that the load is applicable to an electrochemical apparatus, i.e., respecting the physical constraints.

The method then comprises machine-learning a plurality of basis functions each representing a respective elementary intermittent load. The plurality of basis function provides a finite dimensional projection space for the plurality of time series. The method may machine-learn the plurality of basis functions using any known methods to obtain a projection space for a time series. In examples, the finite dimensional projection space may be an optimal projection space. By an optimal projection space it is meant a projection space which, for a certain dimensionality of said projection space (i.e., a given number of basis functions) provides a minimum projection error on said space. The projection error may be according to any known metric. In particular, the optimal projection space may have a smaller dimension than the dimension required to precisely define the provided plurality of time series. In this aspect, the optimal projection space provides a dimensionally reduced space (thereby a reduced complexity) to describe the time series. Such a reduced dimension space is rich enough to describe sufficiently accurate the provided time series and any anticipated intermittent load using the basis functions in order to obtain an accurate and fast predictive model. In examples, the number of basis functions may be smaller than 50, or 25, or 15. The projection space is a linear projection space, thereby the plurality of basis function is configured for approximating each time-series by a respective succession of linear combinations applied to the plurality of basis functions.

In examples, the plurality of basis functions may comprise a plurality of shapelets. In other words, the method may identify the plurality of basis functions (using machine-learning) to obtain a shapelet decomposition/learning of the intermittent load. Alternatively, the plurality of basis function may comprise a plurality of Fourier functions (i.e., providing a Fourier decomposition) or a plurality of wavelet functions (i.e., providing a wavelet decomposition). The shapelet decomposition provides an extension over the Fourier decomposition and/or wavelet decomposition. As Fourier decomposition decomposes a signal by its (eigen) frequencies, wavelet decomposition decomposes a signal by its frequencies and orders. Wavelet decomposition identifies main frequencies further to providing information on the localization of the main perturbation and to regulate a signal. On the other hand, shapelet learning enables to decompose a signal in frequencies, orders and patterns. In other words, shapelet learning identifies representative patterns of a signal and to directly identify the patterns. Further to this, a shapelet learning enables to simultaneously decompose a signal based on a classification label. Considering such labels in decomposing a signal is particularly important in application in performance evolution prediction on apparatus subject to renewable energy sources. Such sources display high variation to the weather conditions (e.g., wind, cloud, sun, ...) and/or time of the day or year (day/night, winter/summer, etc.). For example, the output profile (and patterns thereof) of a solar panel during a sunny summer day may be significantly different from said profile of a winter night or a rainy day. Thereby it is important to consider an additional parameter to decompose the pattern among similar data of comparable working conditions of the electrochemical apparatus. Using shapelet learning provides such an ability for example using the metadata of the provided timeseries to improve he machine-learning step. At the beginning of the learning process, shapelet learning may start with parts of the signal at hand. But as the learning iterates (e.g., over the epochs) a mix or average out between said parts of the signal is obtained in order to have the best compromise. In other words, the shapelet learning takes a signal, cuts the signal into smaller pieces, then modifies the smaller pieces so as to reduce the Dynamic Time Wrapping (DTW) metric and keeps the best pieces according to said metric.. In some examples, shapelet learning may use a genetic algorithm using a DTW as choosing metric. In examples, a linear combination of shapelets is determined for different time intervals of the considered time series. The temporal subdivision is determined by an optimization algorithm as known in the field of General Additive Models (GAMs) for details.

The method then determines a plurality of elementary evolutions for each of the basis functions. Each elementary evolution comprises a respective elementary evolution of the performance indicator for the electrochemical apparatus, if the electrochemical apparatus is subjected to the respective elementary intermittent load represented by the basis function. In other words, the method may involve a test program in which the electrochemical apparatus is subjected to a plurality of (elementary) intermittent loads. Examples of such a test program are discussed further below.

As discussed above, the method is a method for generating a predictive model. The (generated) predictive model is a function that takes the anticipated intermittent load as input and that outputs a predicted evolution of the performance indicator for the electrochemical apparatus when subject to the anticipated intermittent load. For that, the function comprises (in a first functional block) projection of the anticipated intermittent load on the plurality of basis function. Such a projection yields a respective succession of linear combinations applicable to the plurality of basis functions to approximate the anticipated intermittent load. The projection function is directly outputted by the machine-learning step. The predictive model further comprises application of the respective succession of linear combinations (as further outputted by the machine-learning step) to the plurality of elementary evolutions, thereby outputting the predicted evolution. The respective succession of linear combinations comprises, for each linear combination and each basis function, a respective scalar coefficient. Said respective scalar coefficient is the coefficient that is applied to the respective elementary evolution which corresponds to the basis function.

In examples (e.g., of the test program discussed above), the determining of a respective elementary evolution of the performance indicator for the electrochemical apparatus comprises, for each basis function obtaining at least one physical instance of the electrochemical apparatus. By a "physical instance" it is meant an instance of the electrochemical apparatus of a certain class (as discussed above) in the real-world. The instance of the electrochemical apparatus (of said certain class) is defined by a set of specifications that defines its behavior in terms of evolution of performance when subject to intermittent loads. The set of specifications may comprise any technical characteristics (e.g., nominal power, voltage response, materials, etc.) that control and define a behavior of the apparatus in function. A physical instance is then a real-world hardware meeting all the specifications and thus forming a working version of the electrochemical apparatus.

The determining may then comprise subjecting the at least one physical instance of the electrochemical apparatus to at least one actual instance of the respective elementary intermittent load represented by the basis function. The determining may further comprise performing at least one measurement of the performance indicator on the at least one physical instance of the electrochemical apparatus, and computing the respective elementary evolution based on the at least one measurement. For example, the elementary measurement may be a measurement of a maximal capacity or power of the electrochemical apparatus and the elementary evolution may be an elementary degradation caused to the physical instance of the apparatus by the actual instance of the respective elementary intermittent load.

In examples, the at least one measurement of the performance indicator on the at least one physical instance of the electrochemical apparatus may comprise a first measurement and a second measurement. The first measurement may be performed at a start of the at least one actual instance of the respective elementary intermittent load. The second measurement may be performed at an end of the at least one actual instance of the respective elementary intermittent load. In other words, the method may provide at least two measurements, one at the start and another one at the end of each load. The computing of the respective elementary evolution may comprise calculating a difference between a value obtained from the second measurement and a value obtained from first measurement. Such a difference may indicate an evolution (i.e., a variation) of the performance indicator corresponding to the elementary intermittent load represented by the basis function.

In examples, for at least one basis function, the at least one actual instance of the respective elementary intermittent load represented by the basis function may comprise a plurality of actual instances of the respective elementary intermittent load. In other words, such examples provide a repetitive pattern of an intermittent load to said apparatus. Applying a repetition of an intermittent load makes it possible for the generated model to predict the evolution of the performance indicator in a long run. In particular, in variety of application and under many loading conditions the behavior of the electrochemical apparatus may be considered linear, i.e., without hysteresis. This improves the method to perform a parallel prediction by a plurality of models instead of performing a prediction for a distance time instant.

In examples, each time series may comprise a respective classification label. The machine-learning of the plurality of basis functions may then comprise minimizing, for each time series, a classification error with respect to the classification label, and/or a distance metric between the basis function and the provided time series. The respective classification label may represent a binary classification (i.e., having two label values) or multi-class classification. The distance (or similarity) metric represents a similarity between a time series and a basis function. The classification metric evaluates if the fitted classification of the time series corresponds to a known classification according to the classification label.

In particular, when the plurality of basis functions comprises a plurality of shapelets as discussed above, the obtained shapelets are the ones best representing the classification. In such cases, the disparity metric may be a median representing "how much" a shapelet represents a class. The metric is a lens by which each class is viewed by the shapelets. In such combinations, and regarding the classification fitting to a time series, the method associates to each class, a certain number of shapelets. The metric may then be used to evaluate the distance between the input time series and each shapelet, in each class. The closest class to the time series is then associated to the time series. The aim of shapelet learning is to find the best shapelets that allows for the best fitting of several time series to known classes.

In examples, the distance metric may be a dynamic time wrapping as known in the field. The classification error may be any known classification metric in the field. For example, the classification error may be a cross-entropy loss, for example an L2-penalized cross-entropy loss.

As discussed above, according to some examples, the plurality of basis functions comprises a plurality of shapelets. In such examples, each shapelet may comprise a length parameter and the (step of the) machine-learning of the plurality of basis functions may further comprise determining a length of each shapelet so as to minimize an error. The method may comprise an optimization process for obtaining an optimal length for each shapelet. The optimization process may optimize said length so as to minimize a combination of the distance metric and/or the classification error. The optimization process may be according to any known optimization method in the field. In examples, the optimization process may comprise a neural network or a genetic algorithm, e.g., according to Gendis implementations (according to the Document Vandewiele et al., "GENDIS: Genetic Discovery of Shapelets", Sensors 2021, 21(4), 1059).

Alternatively or additionally, the method may take an input defining a respective length of each shapelet (of the plurality of shapelets). A user may provide said inputs in any manner, for example based on domain knowledge. Such examples may exploit implementations such as tslearn (see https://tslearn.readthedocs.io/en/stable/) to machine-learning the shapelets using the provided input defining the length of the shapelets.

In examples, the machine-learning of the plurality of basis functions may further comprise selecting a subset of a predetermined size from the determined plurality of basis functions. Such examples may be in combination with the examples of the method discussed above in which the machine-learning of the plurality of basis functions comprises minimizing a classification error and/or a distance metric. In such combinations, the selected subset may have a classification error in a first vicinity of the minimizing classification error, and/or a distance metric in a second vicinity of the minimizing distance metric.

Such examples are related to a clustering algorithm to regroup the extracted shapelets (as the determined basis function) into selected shapelets who best represent the shapelet set while retaining the classification power. In particular, due the computational constraints, a shapelet learning process only allows the testing of a certain number of shapelets of a certain maximal length. The length can be determined with a domain knowledge or using an optimization as discussed above. In order to obtain a (desired) number of shapelets a larger number is set to be extracted to allow sufficient search-flexibility to the algorithm. Then the shapelets may be equalized in length by filling by terminal values. The obtained shapelets may be then clustered to a desired number. Then the remaining terminal flat section or cut off. Finally, an inertia criteria is evaluated on the shapelet before and after clustering to verify that the clustering keeps the precision of the classifier.

It is further proposed a computer-implemented method of using a predictive model generated for a respective electrochemical apparatus where the model is generated according to the method discussed above. Such a method of use comprises obtaining an anticipated intermittent load at least partly produced by one or more renewable energy sources. The method of use further comprises applying the predictive model to the anticipated intermittent load. Thus, the method of use outputs a predicted evolution of the performance indicator for the respective electrochemical apparatus, if the respective electrochemical apparatus is subjected to the anticipated intermittent load. The applying of the predictive model includes projecting the anticipated intermittent load on the plurality of basis function, thereby obtaining a respective succession of linear combinations applicable to the plurality of basis functions to approximate the anticipated intermittent load. The applying of the predictive model further includes applying the respective succession of linear combinations to the plurality of elementary evolutions, thereby outputting the predicted evolution.

The methods discussed above, i.e., the method of generating a predictive model, the method of using a generated predictive model, and the method of dataset forming are computer-implemented. This means that steps (or substantially all the steps) of the methods are executed by at least one computer, or any system alike. Thus, steps of the methods are performed by the computer, possibly fully automatically, or, semi-automatically. In examples, the triggering of at least some of the steps of the methods may be performed through user-computer interaction. The level of user-computer interaction required may depend on the level of automatism foreseen and put in balance with the need to implement user's wishes. In examples, this level may be user-defined and/or pre-defined. For instance, the step of obtaining a plurality of time series in the method of generating a predictive model may be performed upon receiving an input from the user. Upon such a receival, said method may automatically perform the remaining steps and generate the predictive model. As another example, the step of obtaining an anticipated intermittent load in the method of using may be performed upon receiving an input by the user. Upon such a receival, said method may automatically apply the predictive model to the anticipated intermittent load, and outputting a predicted evolution of the performance indicator for the respective electrochemical apparatus.

A typical example of computer-implementation of a method is to perform the method with a system adapted for this purpose. The system may comprise a processor coupled to a memory and a graphical user interface (GUI), the memory having recorded thereon a computer program comprising instructions for performing the method. The memory may also store a database. The memory is any hardware adapted for such storage, possibly comprising several physical distinct parts (e.g., one for the program, and possibly one for the database).

FIG. 1 shows an example of the system, wherein the system is a client computer system, e.g., a workstation of a user.

The client computer of the example comprises a central processing unit (CPU) 1010 connected to an internal communication BUS 1000, a random-access memory (RAM) 1070 also connected to the BUS. The client computer is further provided with a graphical processing unit (GPU) 1110 which is associated with a video random access memory 1100 connected to the BUS. Video RAM 1100 is also known in the art as frame buffer. A mass storage device controller 1020 manages accesses to a mass memory device, such as hard drive 1030. Mass memory devices suitable for tangibly embodying computer program instructions and data include all forms of nonvolatile memory, including by way of example semiconductor memory devices, such as EPROM, EEPROM, and flash memory devices; magnetic disks such as internal hard disks and removable disks; magneto-optical disks. Any of the foregoing may be supplemented by, or incorporated in, specially designed ASICs (application-specific integrated circuits). A network adapter 1050 manages accesses to a network 1060. The client computer may also include a haptic device 1090 such as cursor control device, a keyboard or the like. A cursor control device is used in the client computer to permit the user to selectively position a cursor at any desired location on display 1080. In addition, the cursor control device allows the user to select various commands, and input control signals. The cursor control device includes a number of signal generation devices for input control signals to system. Typically, a cursor control device may be a mouse, the button of the mouse being used to generate the signals. Alternatively or additionally, the client computer system may comprise a sensitive pad, and/or a sensitive screen.

The computer program may comprise instructions executable by a computer, the instructions comprising means for causing the above system to perform the method. The program may be recordable on any data storage medium, including the memory of the system. The program may for example be implemented in digital electronic circuitry, or in computer hardware, firmware, software, or in combinations of them. The program may be implemented as an apparatus, for example a product tangibly embodied in a machine-readable storage device for execution by a programmable processor. Method steps may be performed by a programmable processor executing a program of instructions to perform functions of the method by operating on input data and generating output. The processor may thus be programmable and coupled to receive data and instructions from, and to transmit data and instructions to, a data storage system, at least one input device, and at least one output device. The application program may be implemented in a high-level procedural or object-oriented programming language, or in assembly or machine language if desired.

In any case, the language may be a compiled or interpreted language. The program may be a full installation program or an update program. Application of the program on the system results in any case in instructions for performing the method. The computer program may alternatively be stored and executed on a server of a cloud computing environment, the server being in communication across a network with one or more clients. In such a case a processing unit executes the instructions comprised by the program, thereby causing the method to be performed on the cloud computing environment.

Implementations of the methods discussed above are now discussed.

The implementations are related to a methodology to predict the degradation of an apparatus connected to an upstream/downstream intermittent load. The degradation of electrochemical systems, such as electrolyzer, is governed by several factors such as the voltage of the electrode that triggers degradation, the apparition of thermal gradients due to start/stop or load variation, or species diffusion (gas crossover for instance) due to start/stop or load variation. The implementations are able to capture both phenomena. The implementations impose the cell (of an electrochemical apparatus) to stay at a given voltage for a given amount of time (as defined by an amplitude of a shapelet) while reflecting the load variation.

In particular, as renewable sources generally have a periodical energy production pattern (e.g., as response to a periodical input from the sun for those renewable energy resources driven by the sun), it is vital to be able to capture these periodical patterns as characteristics of the energy production at different scale. The implementations deal with a methodology consisting in identifying said patterns, characterize and associate a degradation to each pattern. Then, a predictive model anticipates on the temporal shape of the renewable energy production. The temporal shape is the shape to be projected on the identified patterns. The projection coefficients then are used to combine the various degradations which characterize the patterns, giving an estimation of the expected degradation to come.

The implementations employ shapelet learning which provides a generalization of the Fourier's decomposition and wavelet decomposition to any shapes. Shapelet learning is a machine learning approach of supervised classification. To implement it, the implementations use "LearningShapelets" of the python package tslearn version 0.5.2 (see https://tslearn.readthedocs.io/en/stable/index.html).

In the first step, the implementations collect (i.e., obtain) numerous sets of data (e.g., more than 10 sets of data) of intermittent loads and to use machine learning/artificial intelligence algorithm to generate a base of unitary patterns ($s_i(t)$) on which these functions can be projected. Each unitary pattern is itself a load profile which has a duration of few milliseconds up to few hours.

At the second step, the implementations perform a test program. The test program has as many phases of test as the number of the unitary patterns obtained in the first step. Each phase of the test program consists in applying the load corresponding to a single unitary pattern several times. The typical duration of each test is from 1h to 10000h. The duration of the test may be one year. At the end of each phase, the degradation of the apparatus is monitored by measuring its efficiency compared to the constant mode. The implementations then compute a degradation ($d_i$) per unitary pattern ($s_i$) by dividing the observed degradation by the number of unitary patterns in the phase.

In order to accelerate the test, the implementations conduct a plurality of parallel tests on distinct apparatus. Such a parallel strategy is based on an assumption that the degradation of the system is not affected by its previous lifetime (i.e., no hysteresis). In particular, and for electrolyzers, this is a valid assumption as a linear degradation is observed with time. The cells/stacks are replaced well before a failure occurs as failure causes a change in the degradation slope.

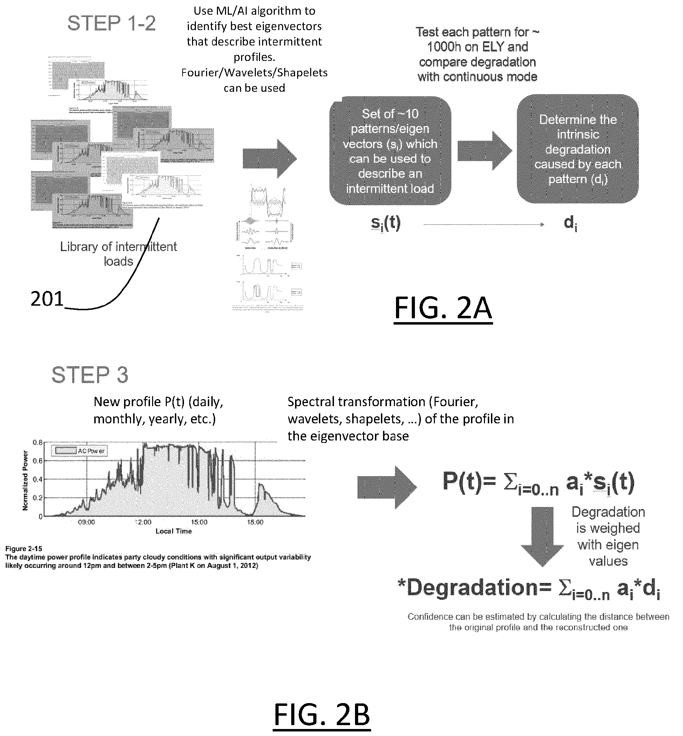

FIG. 2A presents a schematic example of the first and the second steps. In step 1, the implementations collect the large set of data by accessing a library of intermittent loads 201. The implementations then use machine-learning and artificial intelligence algorithms to identity best family of eigen vectors that describe the intermittent profiles that the method obtained. The implementations may use different techniques like Fourier transform, wavelet, or shapelet to identify such eigen vectors. As a result of this step, the implementations may obtain a set comprising a plurality of the identified eigenvectors (or patterns) $s_i$ which can be used to describe an intermittent load. The set may comprise ten eigenvectors. The implementations then test the apparatus (e.g., an electrolyzer) by applying each identified pattern of the set and determine the intrinsic degradation $d_i$ caused by each pattern.

At the third step, the implementations are able to predict the degradation of an apparatus connected to a novel intermittent load profile S(t). The novel load is approximated through a linear combination of the unitary patterns generated in step one as the following:

$$P(t) = S_{i=1..n}\, a_i\, s_i(t).$$

Then the implementations are able to predict the degradation (d) by summing the individual degradations of the used unitary patterns, weighed with the coefficients used for the transformation of the novel load into a linear combination of unitary patterns as the following:

$$d = S_{i=1..n}\, a_i\, d_i.$$

FIG. 2B presents a schematic example of the third step. In this example a new profile P(t) is provided to the method. The profile may be related to a daily, monthly, or yearly power/load. The load is normalized. The implementations compute a spectral transformation of the provided profile, e.g., using Fourier, wavelets, or shapelets and then predicts the degradation as discussed above. The implementations may estimate a confidence level by calculating the distance between the original (i.e., the provided profile) profile and the reconstructed profile (i.e., using the computed spectral transformation).

The implementations may use a similar methodology to predict degradation of other types of apparatus, for example: a family of electrolyzers connected to an intermittent source of power (e.g., renewable energy, hybrid systems, etc.), electrochemical energy storage devices connected to an intermittent source of power, and/or electrochemical energy storage devices connected to an intermittent load (electric motor, etc.) The implementations may also predict other output signals such as temperature, pressure, ion concentration, and/or gas a similar manner.

Metrological aspects of the implementations are now discussed.

As known, shapelet extracting methods are supposed to extract characteristic patterns from a set of signals. In other words, learning shapelets identifies the base shapes of the signals.

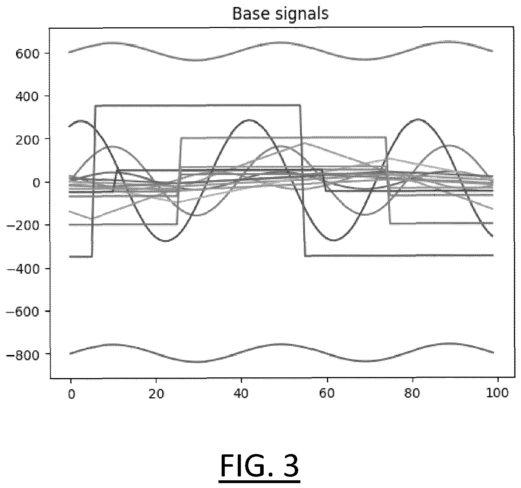

FIG. 3 presents base signals used to generate training and testing data. FIG.s 4A-B show the timeseries in the training set and in the test set, respectively. Two-third of the dataset is devoted to being the training set and the remaining one third is used as the test set.

The shape identified by the implementations at two moments of the process is evaluated to explain the identification process. The implementations are performed by tslearn which is a Python package that provides machine learning tools for the analysis of time series. The tslearn package implements a neural network that modifies its weights after each passing of the entire data set, called epoch, to optimize its performance. The two moments of evaluation are at different number of epochs, one before the convergence (e.g., 3000 epochs) and one where convergence could be considered achieved (e.g., 10000 epochs).

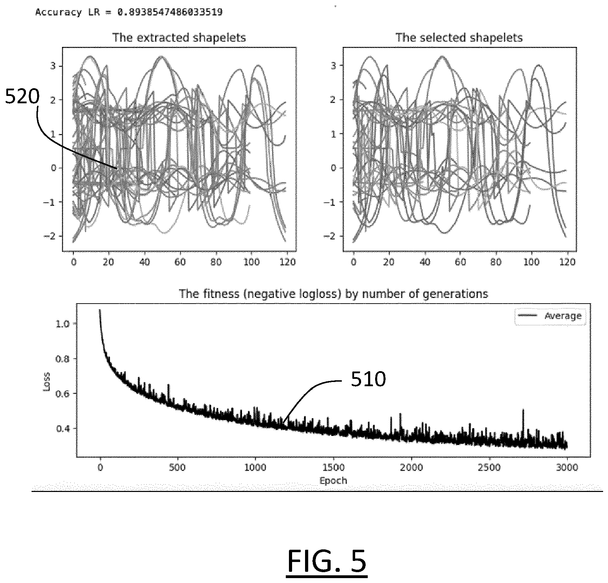

The first moment, i.e., the case of 3000 epochs, is presented in FIG. 5. By looking at the fitness curve 510, it is clear the convergence has not yet been reached. Furthermore, the extracted (i.e., identified) shapelets 520 are a mix of the base signals used to generated training and the testing date as presented in FIG. 3.

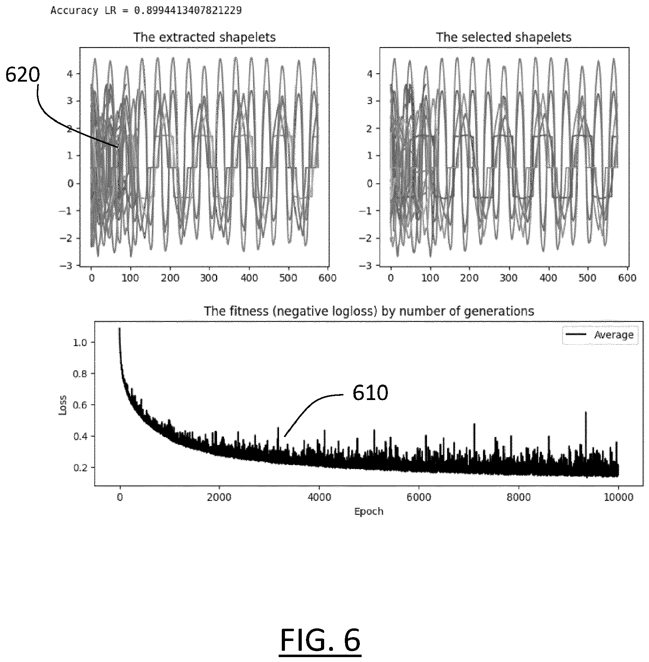

The second moment, i.e., the case of 10000 epochs, is presented in FIG. 6. The fitness curve 610 is lower and flatter compared to 510 in FIG. 5. This shows that convergence has been achieved. Furthermore, the extracted shapelets 620 mostly show the pure base signals used to generate training and the testing date as presented in FIG. 3.

Comparing the accuracy of both trainings of 3000 and 10000 epochs, it increases 0.6% from the first case (of FIG. 5) to the second case (of FIG. 6). Here the accuracy measures the classification performance of the shapelets and not their proximity to the base signals. The exactitude of the shape of the shapelets is not a necessity for a shapelet learning classifier, which rather relies on their difference. However, the correctness of the identified shapes improves the classification performance.

These observations shows that the implementation converges to the correct shapes. In other words, the learning shapelet algorithm, indeed identifies and extract the correct base patterns from a set of signals.

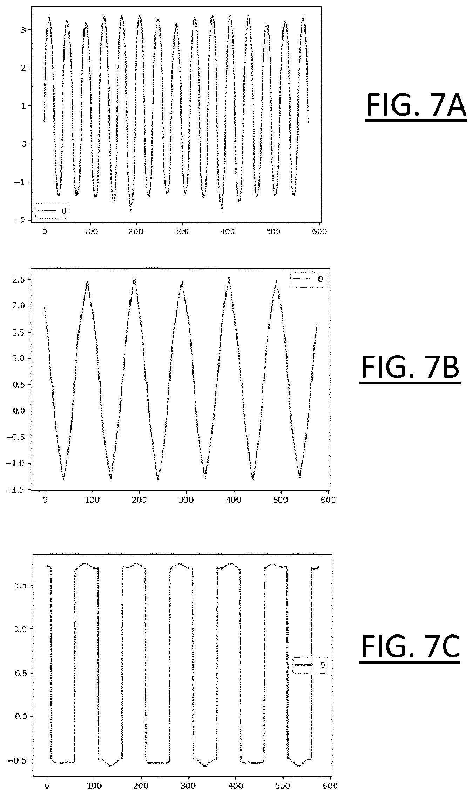

FIG.s 7A-C show examples of extracted shapelets: FIG. 7A is an identified sinus-like signal, FIG. 7B is an identified triangle-like signal, and FIG. 7C is an identified rectangular-like signal.

The implementations gather data sets representing the renewable production over time in different locations and different conditions are gathered and labelled by macroscopics conditions (day/night, winter/summer, solar/wind, climates...). Upon those gathered datasets or examples, the machine learning method may use a metric called "dynamic time wrapping" to calculate a distance or similarity between sub-sections or shapelets of the examples. The length (or duration) of those shapelet can either be determined by an optimizing method or by domain knowledge. The group of shapelets that are the closest to all other possible sub-sections and that best represent the classification given by the user may be retained or extracted. The classification is done by a logistic regression built as a neural network; weights are optimized by stochastic gradient descent on a L2-penalized cross-entropy loss.

Because experimentation on an electrolyzer takes both considerable time and resource, and is subjected to operational constraints, the implementations may use an approach not to explore all possible shapelet lengths. In such an approach the implementations may use a clustering algorithm to regroup the "extracted shapelets" into k "selected shapelets" who best represent the shapelet. The clustering algorithm may select the k selected shapelets so as to retain either x% of the classification power by a logistic regression or x% of the total distance between the shapelets. The value x may be determined by the constraints on the experimental plan that will characterize the degradation to associate for each "selected shapelets".

The experimental plan may optionally be simplified into two concomitants experiences. One may be a baseline scenario that serves as a reference point to which may be compared the second one. The second one may consist of a succession of N repetition of each "selected shapelet". N could be determined by the central limit theorem so that the characterized degradation is statically representative (usually >= 30 if a gaussian distribution is assumed).

## Claims

1. A computer-implemented method of generating a predictive model configured for outputting a predicted evolution of a performance indicator for an electrochemical apparatus subject to an anticipated intermittent load at least partly produced by one or more renewable energy sources, the method comprising:

   - obtaining a plurality of time series each representing a respective real intermittent load at least partly produced by one or more renewable energy sources and configured for subjecting the electrochemical apparatus;
   - machine-learning a plurality of basis functions each representing a respective elementary intermittent load, the plurality of basis function forming a projection space for the plurality of time series, the plurality of basis functions being thereby configured for approximating each time-series by a respective succession of linear combinations applied to the plurality of basis functions; and
   - determining a plurality of elementary evolutions comprising, for each basis function, a respective elementary evolution of the performance indicator for the electrochemical apparatus, if the electrochemical apparatus is subjected to the respective elementary intermittent load represented by the basis function;

   the predictive model comprising:

   • a projection of the anticipated intermittent load on the plurality of basis function, thereby obtaining a respective succession of linear combinations applicable to the plurality of basis functions to approximate the anticipated intermittent load; and
   • an application of the respective succession of linear combinations to the plurality of elementary evolutions, thereby outputting the predicted evolution.

2. The method of claim 1, wherein the determining of a respective elementary evolution of the performance indicator for the electrochemical apparatus comprises, for each basis function:

   - obtaining at least one physical instance of the electrochemical apparatus;
   - subjecting the at least one physical instance of the electrochemical apparatus to at least one actual instance of the respective elementary intermittent load represented by the basis function;
   - performing at least one measurement of the performance indicator on the at least one physical instance of the electrochemical apparatus; and

- computing the respective elementary evolution based on the at least one measurement.

3. The method of claim 2, wherein the at least one measurement of the performance indicator on the at least one physical instance of the electrochemical apparatus comprises a first measurement and a second measurement, the first measurement being performed at a start of the at least one actual instance of the respective elementary intermittent load, the second measurement being performed at an end of the at least one actual instance of the respective elementary intermittent load, the computing of the respective elementary evolution comprising calculating a difference between a value obtained from the second measurement and a value obtained from first measurement.

4. The method of claim 2 or 3, wherein for at least one basis function, the at least one actual instance of the respective elementary intermittent load represented by the basis function comprises a plurality of actual instances of the respective elementary intermittent load.

5. The method of any one of claims 1 to 4, wherein each time series comprises a respective classification label, and the machine-learning of the plurality of basis functions comprises minimizing, for each time series:

   - a classification error with respect to the classification label, and/or
   - a distance metric between the basis function and the provided time series.

6. The method of claim 5, wherein:

   - the distance metric is a dynamic time wrapping, and/or
   - the classification error is a cross-entropy loss.

7. The method of any of claims 1 to 6, wherein the plurality of basis functions comprises a plurality of shapelets.

8. The method of claim 7, wherein each shapelet comprises a length parameter, the machine-learning of the plurality of basis functions further comprising:

   - determining a length of each shapelet so as to minimize an error.

9. The method of claim 7 or 8, further dependent on claim 5, wherein the machine-learning of the plurality of basis functions further comprises:

   - selecting a subset of a predetermined size from the determined plurality of basis functions;

the selected subset having:

   - a classification error in a first vicinity of the minimizing classification error, and/or
   - a distance metric in a second vicinity of the minimizing distance metric.

10. The method of any of preceding claims, wherein the performance indicator represents:

   - an efficiency in constant mode,
   - a temperature signal,
   - a pressure signal,
   - an ion concentration signal, or
   - a gas concentration signal.

11. The method of any of preceding claims, wherein the electrochemical apparatus comprises at least one of:

   - an electrolyzer connected to an intermittent source of power,
   - an electrochemical energy storage device connected to an intermittent source of power, and
   - an electrochemical energy storage device connected to an intermittent load.

12. A computer-implemented method of using a predictive model generated according to the method of any of claims 1 to 11 for a respective electrochemical apparatus, the method comprising:

   - obtaining an anticipated intermittent load at least partly produced by one or more renewable energy sources; and
   - applying the predictive model to the anticipated intermittent load, thereby outputting a predicted evolution of the performance indicator for the respective electrochemical apparatus, if the respective electrochemical apparatus is subjected to the anticipated intermittent load, the applying of the predictive model including:

     ○ projecting the anticipated intermittent load on the plurality of basis function, thereby obtaining a respective succession of linear combinations applicable to the plurality of basis functions to approximate the anticipated intermittent load; and
     ○ applying the respective succession of linear combinations to the plurality of elementary evolutions, thereby outputting the predicted evolution.

**13.** A computer program comprising instructions for performing the method according to any one of claims 1 to 11 and/or the method according to claim 12.

**14.** A computer readable storage medium having recorded thereon the computer program of claim 13.

**15.** A system comprising a processor coupled to a memory, the memory having recorded thereon the computer program of claim 13.

FIG. 1

STEP 1-2

Use ML/AI algorithm to identify best eigenvectors that describe intermittent profiles. Fourier/Wavelets/Shapelets can be used

Test each pattern for ~ 1000h on ELY and compare degradation with continuous mode

Library of intermittent loads

201

Set of ~10 patterns/eigen vectors ($s_i$) which can be used to describe an intermittent load

Determine the intrinsic degradation caused by each pattern ($d_i$)

$s_i(t)$ ⟶ $d_i$

## FIG. 2A

STEP 3

New profile P(t) (daily, monthly, yearly, etc.)

Spectral transformation (Fourier, wavelets, shapelets, ...) of the profile in the eigenvector base

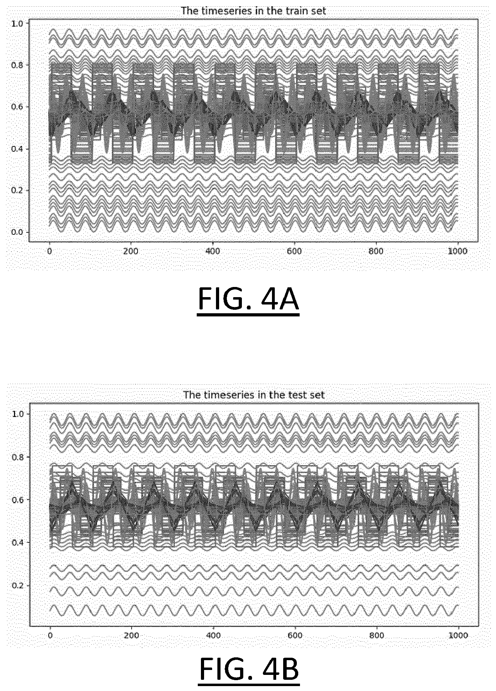

**Figure 2-15**
The daytime power profile indicates party cloudy conditions with significant output variability likely occurring around 12pm and between 2-5pm (Plant K on August 1, 2012)

$$P(t)= \Sigma_{i=0..n}\ a_i{}^*s_i(t)$$

Degradation is weighed with eigen values

$$^*Degradation= \Sigma_{i=0..n}\ a_i{}^*d_i$$

Confidence can be estimated by calculating the distance between the original profile and the reconstructed one

## FIG. 2B

Base signals

## FIG. 3

The timeseries in the train set

FIG. 4A

The timeseries in the test set

FIG. 4B

FIG. 5

FIG. 6

**FIG. 7A**

**FIG. 7B**

**FIG. 7C**

Europäisches
Patentamt

European
Patent Office

Office européen
des brevets

# EUROPEAN SEARCH REPORT

Application Number

EP 23 30 5747

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2022/112612 A1 (MONTALVO ANTONIO [US] ET AL) 14 April 2022 (2022-04-14) * the whole document * | 1-15 | INV. H02J3/28 C25B15/02 H02J7/00 |
| A | CN 115 094 481 A (UNIV HEBEI TECHNOLOGY) 23 September 2022 (2022-09-23) * the whole document * | 1-15 | |
| A | CA 3 191 175 A1 (ANALOG DEVICES INC [US]) 25 August 2022 (2022-08-25) * the whole document * | 1-15 | |
| A | US 2022/186390 A1 (MONTALVO ANTONIO [US] ET AL) 16 June 2022 (2022-06-16) * the whole document * | 1-15 | |

TECHNICAL FIELDS
SEARCHED      (IPC)

H02J
C25B

The present search report has been drawn up for all claims

| Place of search | Date of completion of the search | Examiner |
|---|---|---|
| Munich | 27 September 2023 | Berger, Josef |

EPO FORM 1503 03.82 (P04C01)

## ANNEX TO THE EUROPEAN SEARCH REPORT
## ON EUROPEAN PATENT APPLICATION NO.

EP 23 30 5747

This annex lists the patent family members relating to the patent documents cited in the above-mentioned European search report.
The members are as contained in the European Patent Office EDP file on
The European Patent Office is in no way liable for these particulars which are merely given for the purpose of information.

27-09-2023

| Patent document cited in search report | Publication date | Patent family member(s) | Publication date |
|---|---|---|---|
| US 2022112612 A1 | 14-04-2022 | NONE | |
| CN 115094481 A | 23-09-2022 | NONE | |
| CA 3191175 A1 | 25-08-2022 | CA 3191175 A1 | 25-08-2022 |
| | | CN 116324042 A | 23-06-2023 |
| | | EP 4185738 A1 | 31-05-2023 |
| | | WO 2022177764 A1 | 25-08-2022 |
| US 2022186390 A1 | 16-06-2022 | NONE | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **VANDEWIELE et al.** GENDIS: Genetic Discovery of Shapelets. *Sensors,* 2021, vol. 21 (4), 1059